(19) Europäisches Patentamt

European Patent Office

Office européen des brevets

(11) **EP 2 160 808 B1**

(12) **FASCICULE DE BREVET EUROPEEN**

(45) Date de publication et mention
de la délivrance du brevet:
**12.03.2014 Bulletin 2014/11**

(21) Numéro de dépôt: **08760812.1**

(22) Date de dépôt: **11.06.2008**

(51) Int Cl.:
*H01L 33/00* (2010.01)    *H01L 33/20* (2010.01)
*H01L 33/22* (2010.01)    *B82Y 20/00* (2011.01)
*H01L 33/10* (2010.01)    *H01S 5/028* (2006.01)
*H01S 5/10* (2006.01)    *H01S 5/125* (2006.01)
*H01S 5/34* (2006.01)

(86) Numéro de dépôt international:
**PCT/EP2008/057254**

(87) Numéro de publication internationale:
**WO 2009/000645 (31.12.2008 Gazette 2009/01)**

(54) **PROCEDE DE FABRICATION DE DISPOSITIFS DE LUMIERE OPTIMISE PAR L'UTILISATION DE MATERIAUX ARTIFICIELS**

**VERFAHREN ZUR HERSTELLUNG OPTIMIERTER BELEUCHTUNGSVORRICHTUNGEN UNTER VERWENDUNG KÜNSTLICHER MATERIALIEN**

**METHOD OF MANUFACTURING OPTIMIZED LIGHT DEVICES USING ARTIFICIAL MATERIALS**

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **22.06.2007 FR 0704503**

(43) Date de publication de la demande:
**10.03.2010 Bulletin 2010/10**

(73) Titulaire: **THALES**
**92200 Neuilly-sur-Seine (FR)**

(72) Inventeurs:
• **LEE-BOUHOURS, Mane-Si, Laure**
**F-91470 Les Molieres (FR)**
• **GARCIA, Michel**
**F-28700 Auneau (FR)**

• **BANSROPUN, Shailendra**
**F-75006 Paris (FR)**
• **LOISEAUX, Brigitte**
**F-91440 Bures Sur Yvette (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A- 0 966 077      EP-A- 1 434 320**
**WO-A2-03/044841      US-A1- 2004 219 704**
**US-B1- 6 483 635**

**Description**

La présente invention concerne un procédé de fabrication de dispositifs émetteurs de lumière. Plus précisément, elle vise à réaliser des émetteurs de lumière au rendement amélioré par l'utilisation de matériaux artificiels, lesdits matériaux artificiels permettant d'obtenir des traitements antireflet ou haute réflectivité précis. Par ailleurs, le procédé de fabrication selon l'invention présente l'avantage de pouvoir être collectif et de réduire le nombre d'étapes technologiques nécessaires.

L'invention s'applique à tout émetteur ou amplificateur de lumière et donc notamment aux lasers, et plus particulièrement encore aux lasers à cascade quantique (ou QCL pour Quantum Cascade Laser en anglais). A titre d'exemple, le cas des lasers à cascade sera plus particulièrement exposé.

Dans le but d'améliorer le rendement de ces sources lasers, on effectue couramment des traitements sur les faces externes des cavités émissives, l'objectif de ces traitements est généralement d'obtenir soit une fonction antireflet, c'est-à-dire une réflectivité la plus proche possible de 0%, typiquement sur la face de sortie de la cavité laser, soit une fonction haute réflectivité, c'est-à-dire une réflectivité la plus proche possible de 100%, typiquement sur la face opposée à la face de sortie.

Actuellement, dans le but d'obtenir l'effet recherché, à savoir l'antireflet ou la haute réflectivité, une technologie couramment utilisée consiste à déposer des couches minces de matériau diélectrique sur la tranche du laser après clivage de la zone émettrice. Cette technologie permet d'améliorer de façon très significative (typiquement 250%) le rendement de ces sources lasers. En effet, d'un point de vue théorique, pour obtenir la fonction antireflet sur un substrat d'indice de réfraction substrat pour une onde lumineuse de longueur d'onde À, il faut idéalement déposer sur ce substrat une couche d'un matériau d'indice de réfraction $n_{AR}$ égal à $\sqrt{n_{substrat}}$ sur une épaisseur de $\dfrac{\lambda}{4.n_{AR}}$. La réflectivité à l'interface air - substrat est alors théoriquement de 0%. Cependant, le nombre de matériaux existant étant limité, il est très difficile et contraignant d'obtenir un matériau à déposer ayant l'indice de réfraction adapté.

Afin de contourner cet inconvénient, on pratique généralement des dépôts multicouches. Mais un autre inconvénient majeur lié à cette technologie subsiste. Il réside dans le fait qu'il est nécessaire de manipuler directement les barrettes de lasers après clivage afin de réaliser les dépôts sur chacune des faces externes de la cavité. La dimension des puces n'excédant pas quelques millimètres de large pour quelques millimètres de long, ces traitements s'avèrent complexes. De plus, en ce qui concerne les QCL, du fait des longueurs d'onde d'émission élevées de ces derniers (ces sources sont utilisées dans des domaines pouvant aller de l'infrarouge au THz), les épaisseurs des couches déposées atteignent rapidement des valeurs critiques, posant des problèmes tels que la tenue mécanique ou les contraintes induites. De ce fait, la fiabilité incertaine de ces traitements complexes remet actuellement en cause leur utilisation.

Une autre technologie permettant de régler la réflectivité des faces externes de cavités lasers consiste à graver sur lesdites faces des microstructures pouvant être plus petites que la longueur d'onde dans une direction transverse à celle dans laquelle se propage la lumière dans la cavité. On parle alors de structures sub-longueur d'onde. Cette technologie peut théoriquement permettre d'obtenir des traitements antireflets ou des traitements haute réflectivité précis. Cependant, la réalisation de lasers exploitant cette technologie est actuellement très difficile. Elle nécessite de réaliser des gravures à l'échelle sub-longueur sur des cavités lasers clivées, en plusieurs phases, afin d'obtenir un traitement antireflet sur la face de sortie et un traitement haute réflectivité sur la face opposée. De plus, le clivage unitaire de cavités lasers ne permet pas de garantir leur longueur. En conséquence, les procédés de fabrication de tels lasers est aujourd'hui complexe, coûteuse, et de qualité incertaine.

En résumé, les technologies existantes visant à l'amélioration du rendement d'émetteurs de lumière, telles que des sources lasers par exemple, notamment par l'intermédiaire de traitements antireflets, sont difficiles à mettre en oeuvre. De plus, leurs performances et leur fiabilité ne sont pas assurées.

Dans le but de pallier les inconvénients précités, l'invention propose un procédé de fabrication de dispositifs émetteurs de lumière au rendement amélioré, ce procédé de fabrication pouvant être collectif.

Plus précisément, l'invention repose sur l'exploitation de matériaux artificiels dont on peut régler l'indice de réfraction, ces matériaux artificiels étant obtenus par gravure de structures sub-longueurs d'onde, comme expliqué précédemment. L'invention permet de fabriquer, notamment de façon collective, des cavités lasers dont les faces externes présentent des traitements antireflets ou des traitements haute réflectivité précis, aboutissant à la réalisation d'émetteurs de lumière optimisés.

A cet effet, l'invention a pour objet un procédé de fabrication collectif d'une pluralité de dispositifs laser à partir d'un substrat constitué d'un empilement de couches de matériau semiconducteur destinées à constituer des cavités des dispositifs laser, le substrat comprenant une zone active incluse dans l'empilement de couches de matériaux semi-conducteurs, et dans laquelle peut se propager, selon une direction de propagation, un faisceau lumineux présentant une ou plusieurs longueurs d'onde, le procédé comportant :

- la réalisation d'un masque de gravure unique présentant une pluralité de zones, une zone correspondant à un dispositif laser et comprenant :

*une partie permettant la gravure de voies de clivage permettant la séparation des cavités laser

*une partie permettant la gravure d'une paroi comprenant des structures verticales de dimension plus petite que la longueur d'onde dans une direction transverse à la direction de propagation du faisceau lumineux, ces structures appelées structures sub-longeur d'onde constituant une structure anti-reflet assurant une fonction anti-reflet c'est-à-dire une réflectivité inférieure à 10% vis-à-vis de la ou des longueurs d'onde, la paroi constituant une face de sortie orthogonale au faisceau lumineux,

*une partie permettant la gravure d'une seconde paroi constituant une structure haute réflectivité c'est-à-dire possédant une réflectivité supérieure à 90% vis-à-vis de la ou des longueurs d'onde, la seconde paroi étant opposée et parallèle à la paroi constituant la structure anti reflet, la structure haute réflectivité étant constituée d'une alternance de N strates à indice de réfraction fort, c'est à dire supérieur ou égal à 3, et de (N-1) strates d'air , les strates étant d'épaisseur optique égales, ladite structure haute réflectivité formant un miroir de bragg,

le dit procédé comportant en outre :

• une unique étape de gravure du substrat à travers le masque unique, des structures verticales sub-longueur d'onde (5), des structures haute réflectivité (HR) ainsi que des voies de clivages (VC) de manière à réaliser collectivement les dispositifs laser comprenant les cavités émissives laser dont la longueur est imposée par le masque, la gravure reposant sur l'utilisation d'une source plasma haute densité.

" Avantageusement, la zone active de la pluralité de dispositif de lumière est formée d'un nombre entier de périodes constituées chacune d'un empilement de couches épitaxiées de matériaux semi-conducteurs tels que InGaAs, AlInAs, GaAs, AlGaAs, InP, de manière à constituer par exemple un laser à cascade quantique (ou QCL pour Quantum Cascade Laser en anglais).

Avantageusement, le procédé de fabrication selon l'invention permet la réalisation d'un dispositif de lumière tel que :

•   le faisceau lumineux présente une longueur d'onde de 9 $\mu$m,

•   chacune des strates de la structure à haute réflectivité possède une épaisseur optique d'environ 2,2 $\mu$m,

•   la structure antireflet présente une période d'environ 2,9 $\mu$m, une profondeur d'environ 1,3 $\mu$m, une largeur d'environ 0,5 $\mu$m et une hauteur gravée supérieure à 9 $\mu$m.

Avantageusement, la source plasma haute densité est obtenue par couplage inductif (ICP pour Inductively Coupled Plasma en anglais).

Avantageusement, la gravure dans un substrat constitué d'un empilement de couches de matériaux semi-conducteurs formant une cavité émissive repose sur l'utilisation d'une technologie de gravure RIE (pour Reactive Ion Etching selon l'acronyme anglais).

D'autres caractéristiques et avantages de l'invention apparaîtront à l'aide de la description qui suit faite en regard des dessins annexés qui représentent :

•   la figure 1 : l'illustration schématique d'un laser à cascade quantique (QCL) selon l'art connu ;

•   la figure 2 : le schéma d'un traitement antireflet par gravure de structures sub-longueur d'onde ;

•   la figure 3 : le graphique démontrant la possibilité de régler avec précision l'indice de réfraction d'une surface par gravure de structures sub-longueur d'onde ;

•   la figure 4a : le schéma de l'association entre une structure antireflet et une structure à haute réflectivité dans un laser, les traitements antireflet et haute réflectivité étant réalisés à l'aide de structures sublongueurs d'onde gravées ;

•   la figure 4b : le schéma d'une structure à haute réflectivité constituée d'une alternance de strates comportant des structures sub-longueur d'onde ;

•   la figure 4c : le schéma d'une structure à haute réflectivité obtenue par gravure de structures sub-longueur d'onde variées dans une tranche située à l'extrémité d'une cavité émissive d'un dispositif émetteur de lumière ;

•   la figure 5 : lue masque unique permettant la fabrication collective de dispositifs selon l'invention.

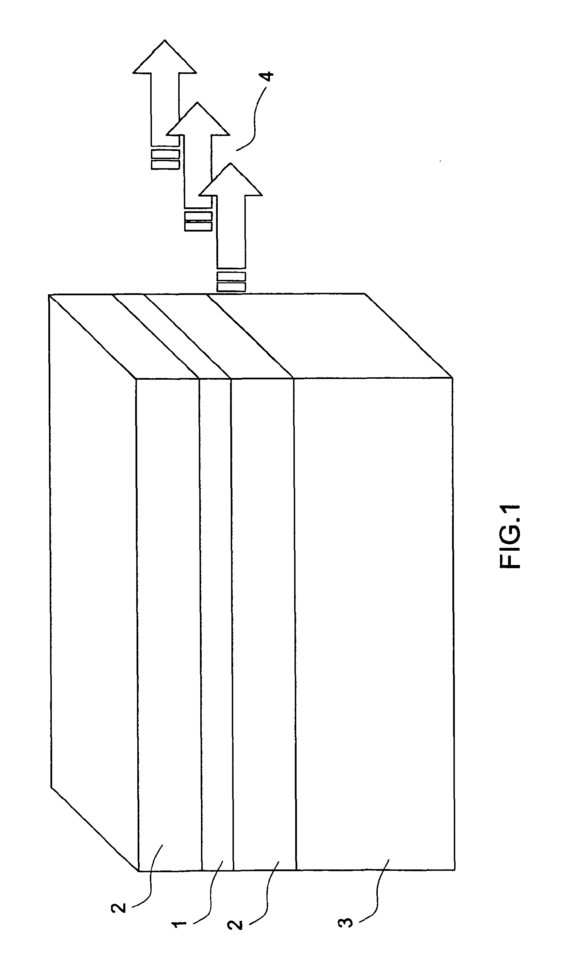

La figure 1 présente un schéma simplifié du fonctionnement d'un laser à cascade quantique selon l'art connu. Le laser à cascade se différencie des lasers classiques par la spécificité de sa zone active 1. Celle-ci est formée d'un certain nombre de périodes, chacune d'elle étant constituée de plusieurs dizaines de couches épitaxiées de matériaux semi-conducteurs (tels que InGaAs, AlInAs, GaAs, AlGaAs, InP par exemple).

Lorsqu'on injecte un courant électrique dans cette zone active 1, les électrons acquièrent de l'énergie qu'ils restituent par effet cascade, chaque fois sous la forme d'un photon. L'engineering du matériau (nature du semi-conducteur, épaisseur des couches épitaxiées...etc.) détermine la longueur d'onde d'émission du laser. Les guides 2 permettent une amplification de la lumière qui est émise en sortie du laser sous la forme d'un faisceau 4. Par ailleurs, on effectue la croissance de la zone active 1 et des guides 2 sur un quelconque substrat 3 qui assure la fonction de support mécanique.

Généralement, les pertes par réflexion en sortie du laser pour des QCL sont de l'ordre de 25% pour une zone active en InP du fait de l'écart entre l'indice de réfraction de l'InP, qui vaut environ 3 pour une longueur d'onde de 9 $\mu$m, et l'indice de réfraction de l'air, qui est proche de 1.

C'est notamment pour limiter ces pertes qu'il est nécessaire de pratiquer un traitement antireflet sur la face de sortie du laser et d'introduire une haute réflectivité sur l'autre face. A cet effet, on utilise aujourd'hui les technologies imparfaites décrites en préambule (en particulier le dépôt de couche(s) mince(s)). L'invention propose d'utiliser des matériaux dits artificiels, comportant des structures sub-longueurs d'onde gravées, pour améliorer le contrôle des fonctions antireflet et haute réflectivité que l'on souhaite introduire.

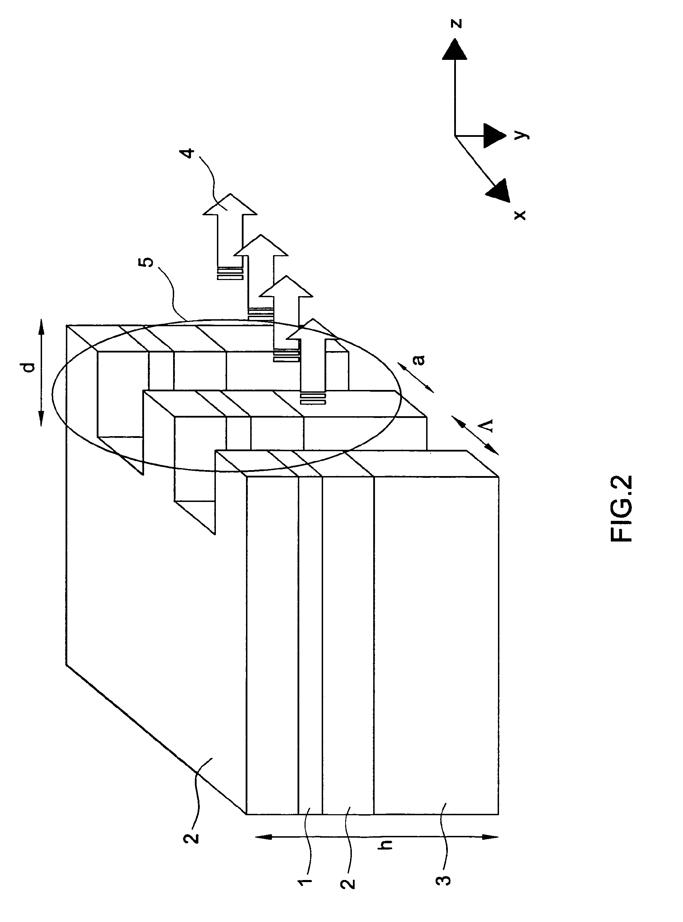

Ainsi, la figure 2 présente un schéma d'un matériau artificiel obtenu par gravure de structures sub-longueur d'onde 5. Comme cela a été expliqué précédemment, il est possible sur le plan théorique de traiter antireflet à la longueur d'onde $\lambda$, tout substrat d'indice de réfraction $n_{substrat}$ en déposant à la surface de celui-ci une couche mince d'un matériau d'indice de réfraction

$n_{AR}$ égal à $\sqrt{n_{substrat}}$ sur une épaisseur de $\dfrac{\lambda}{4.n_{AR}}$.

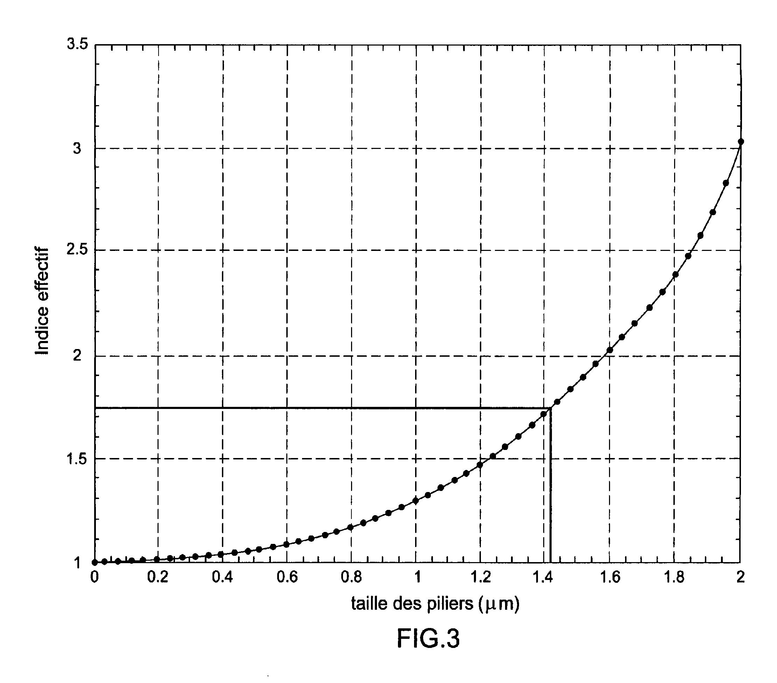

Or, la maîtrise actuelle des micro-technologies permet de graver des structures sub-longueur d'onde. Il peut s'agir de traits, trous, piliers ou d'autres géométries simples gravés dans un substrat. La théorie des milieux effectifs enseigne alors que, de façon simplifiée, la lumière incidente illuminant le substrat ne « perçoit » pas les structures sub-longueurs d'onde gravées, mais un milieu homogène artificiel dont l'indice de réfraction, appelé indice effectif, est compris entre l'indice de réfraction du matériau constitutif du substrat et celui de l'air. Ainsi, en fonction de la taille (largeur a), de la forme géométrique (cylindre, parallélépipède rectangle ...etc.) et de la période $\Lambda$ des structures sub-longueur d'onde gravées, il est possible de régler l'indice moyen local du matériau artificiel obtenu, comme le montre la figure 3.

La figure 3 représente l'évolution de l'indice effectif d'un matériau artificiel basé sur un substrat en InP dans lequel ont été gravées des microstructures avec une période de 2 $\mu$m, le substrat étant illuminé en incidence normale à une longueur d'onde de 9 $\mu$m en lumière non polarisée. Sachant que l'InP a un indice de réfraction intrinsèque $n_{InP}$ de 3,037 à 9 $\mu$m, on constate que la gravure, avec une périodicité de 2 $\mu$m, de piliers de largeur a valant environ 1,41 $\mu$m permet de réaliser un matériau artificiel d'indice de réfraction

$n_{AR} = 1,74 = \sqrt{n_{InP}}$ ; en gravant ces microstructures sur une profondeur $d = \dfrac{\lambda}{4.n_{AR}} = 1,29 \mu m$, on obtient donc un antireflet théoriquement parfait.

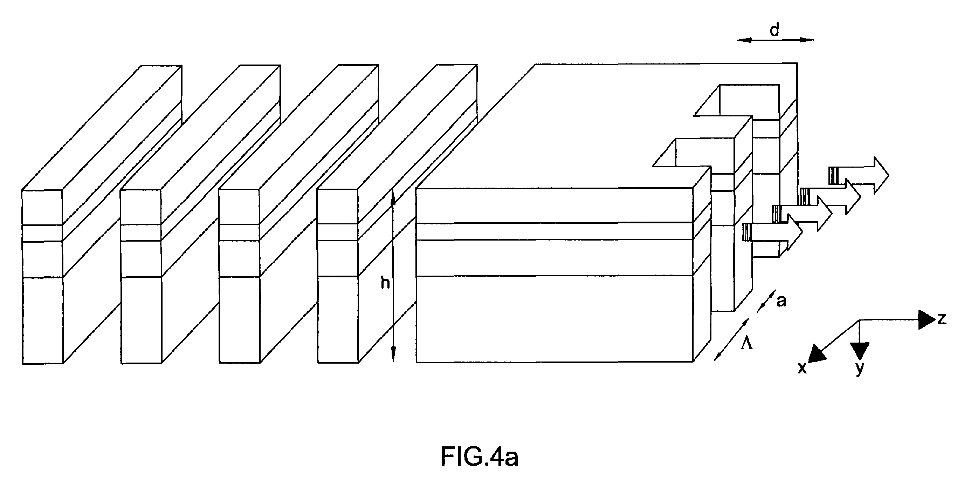

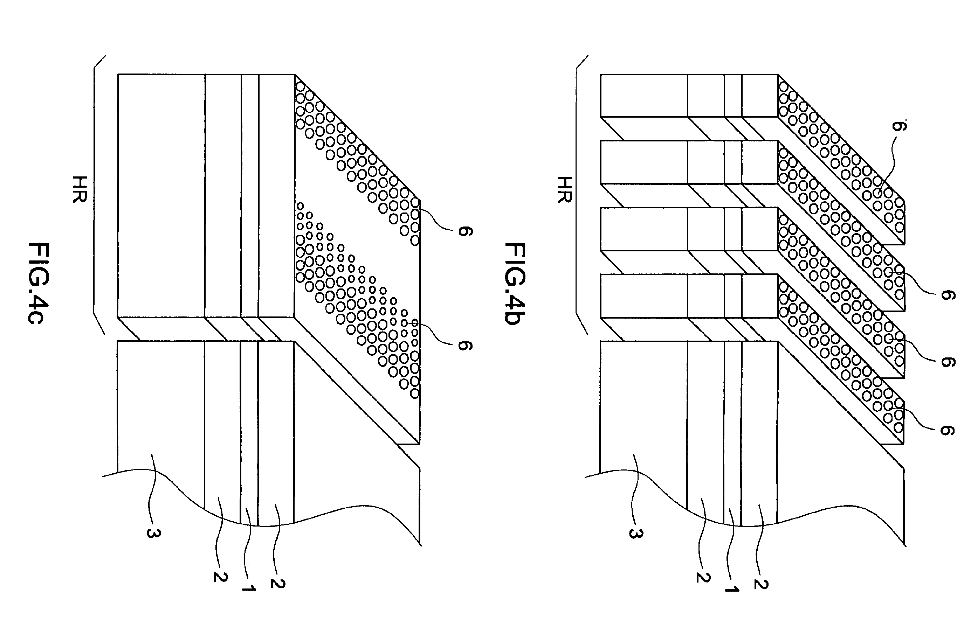

La figure 4a présente l'association entre une structure antireflet AR telle que décrite dans la figure 2 et une structure à haute réflectivité HR dans le but de réaliser un laser, et plus particulièrement un laser à cascade quantique. La structure à haute réflectivité est un miroir de Bragg constitué de paires de structures associant une couche à fort indice de réfraction et une couche à faible indice de réfraction. La réflectivité du miroir HR dépend du nombre de paires et de l'écart d'indice entre les différentes strates ainsi que des épaisseurs optiques des différentes strates. Dans l'exemple de la figure 4, la structure HR est composée de quatre strates de matériau émissif séparées par l'intermédiaire de trois strates d'air.

Comme le montre la figure 4b, il peut s'agir, dans l'absolu, d'une alternance de strates de matériaux artificiels. Le principe de réalisation de ces matériaux artificiels est alors le même que pour les structures AR présentées en figure 2. Simplement, des structures sub-longueur d'onde 6 différentes, notamment en termes de taille et de géométrie, sont gravées. Par exemple, on peut graver des trous cylindriques dans chaque strate de matériau de la structure HR. De plus, les strates peuvent toutes être d'épaisseur différente ; leur espacement peut également être variable. On acquiert ainsi, de façon indépendante, un contrôle de l'indice de réfraction de chacune des strates constituant le miroir HR. Par voie de conséquence, on aboutit à un contrôle en longueur d'onde de l'émission du laser.

La figure 4c montre par ailleurs que l'on peut graver des structures sub-longueurs d'onde variées 6 dans une tranche située au niveau de l'extrémité de la cavité émissive dont elle est plus ou moins éloignée. Le réglage de cet éloignement entre la structure HR et la cavité émissive permet d'adapter la réflectivité de la structure HR. Ces structures sub-longueur d'onde 6 peuvent par exemple être des trous cylindriques, de divers diamètres.

Dans un exemple d'application, on s'intéresse au cas d'un laser à cascade quantique émettant à 9 $\mu$m en polarisation TM (c'est-à-dire que le champ électrique de la zone émissive 1 du laser est perpendiculaire au plan des empilements de couches de la zone active 1 du laser à cascade quantique), constitué de strates présentant différents indices de réfraction variant autour de l'indice de réfraction de l'InP, une structure AR comportant des structures sub-longueurs d'onde permet d'obtenir une réflectivité inférieure à 0,2% grâce aux moyens technologiques actuels. De même, une structure HR composée de deux strates du matériau constitutif de la cavité émissive du laser à cascade quantique d'une épaisseur e égale à 0,7 $\mu$m chacune, séparées d'une couche d'air de 2,2 $\mu$m d'épaisseur, permet d'atteindre une réflectivité de 95,4%. Dans le cas d'une structure composée de trois couches de matériau émissif séparées de couches d'air, la réflectivité obtenue est portée à 99,5%.

On a vu que la gravure de structures sub-longueurs d'onde sur les faces externes de cavités lasers, ou de tout dispositif émetteur ou amplificateur de lumière, permettait d'en régler la réflectivité avec précision. La difficulté à résoudre est celle de la réalisation de ces traitements antireflet ou haute réflectivité sur des cavités dont les dimensions n'excèdent pas quelques millimètres.

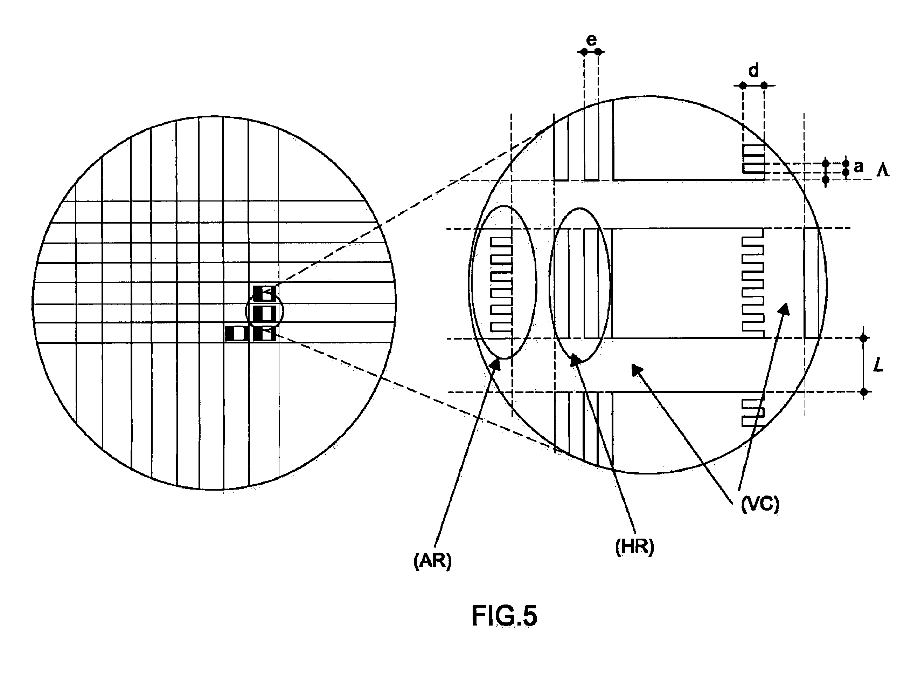

La figure 5 illustre la possibilité de réaliser des dispositifs de lumière, et notamment des lasers à cascade quantique, intégrant des structures sub-longueurs d'onde, grâce à un procédé simple, pouvant être collectif, et reposant sur l'utilisation d'un masque unique. Les éléments dimensionnant pour les performances des cavités lasers produites selon ce procédé sont les dimensions longitudinales et transversales des structures AR et HR, à savoir d, a, Λ et e. En revanche, les performances ne dépendent pas de la profondeur h de la gravure pour laquelle la seule condition est qu'elle doit être supérieure ou égale à la hauteur de la cavité laser. Dans ces conditions, la figure 5 démontre bien que l'on peut, orthogonalement au plan sur lequel on positionne l'empilement de couches épitaxiés constitutives de la cavité laser, graver les fonctions antireflet AR et haute réflectivité HR, ainsi que des voies de clivage VC, qui permettront la séparation des cavités lasers réalisées de façon collective, par l'intermédiaire d'un masque unique. Ces voies de clivage VC sont positionnées immédiatement après les structures HR et AR.

Dans un exemple d'application concret réalisé avec un laser à cascade quantique émettant à 9 $\mu$m en polarisation TM, la structure antireflet AR possède une hauteur d d'environ 1,3 $\mu$m, une largeur a égale à 0,5 $\mu$m et une période Λ valant 2,9 $\mu$m. Ces microstructures ont par ailleurs été gravées sur une profondeur h environ égale mais supérieure à 9 $\mu$m. Avec ces paramètres, l'élément AR présente une réflectivité inférieure à 0,2%. La structure HR est composée de deux strates de matériaux épitaxiés constitutives de la cavité laser séparées d'une couche d'air, chaque strate présentant une épaisseur optique d'environ 2,2 $\mu$m, l'épaisseur optique étant le produit de l'épaisseur e par l'indice de réfraction de la strate. Les strates de matériaux épitaxiés, constitués de matériaux dont les indices de réfraction varie autour de celui de l'InP, soit environ 3, ont donc une épaisseur d'environ 0,7 $\mu$m tandis que les strates d'air intermédiaires ont une épaisseur de 2,2 $\mu$m, l'indice de réfraction de l'air étant environ égal à 1. De cette façon, l'élément HR possède une réflectivité supérieure à 95%. Les voies de clivage permettant la séparation des cavités lasers ainsi réalisées sont gravées sur une profondeur environ égale mais supérieure à 10 $\mu$m ; la largeur L de ces voies de clivages vaut environ 100 $\mu$m.

L'utilisation de ce masque unique pour la gravure des structures AR et HR ainsi que des voies de clivages, en une seule étape, y compris pour la réalisation collective de cavités lasers, constitue un avantage important. De plus, la qualité des cavités produites, et notamment leur longueur, est maîtrisée. Cela permet de produire un grand nombre de cavités lasers présentant des performances très homogènes.

Pour réaliser les gravures profondes de microstructures telles que décrites ci-dessus, on peut utiliser une source plasma haute densité (HPD pour High Plasma Density en anglais) et, plus particulièrement, un système ICP (pour Inductively Coupled Plasma en anglais) permettant de réaliser des gravures sèches dans un plasma obtenu par couplage inductif. Cette technique permet de contrôler séparément l'énergie et la densité de flux des ions sur l'échantillon à graver. Une induction produit un plasma au voisinage du substrat alors qu'une source capacitive indépendante imprime aux espèces fortement dissociées l'énergie cinétique souhaitée. Contrairement aux autres méthodes de génération de plasma, l'ICP a l'avantage de produire des plasmas de haute densité ionique indépendamment de l'énergie des ions réactifs. Une polarisation indépendante de la source permet d'accélérer les ions vers le substrat, ce qui permet de contrôler l'aspect chimique et physique de la gravure et donc de maîtriser la vitesse de gravure, l'anisotropie et la qualité de surface. Le système ICP permet par exemple de graver des trous de dimensions submicroniques sur une profondeur d'environ 5 $\mu$m avec un bon rendu de surface dans un substrat GaAs.

Par ailleurs, l'utilisation d'un système ICP permet la réalisation de gravures profondes de structures dont les dimensions sont de l'ordre du micron sans altérer la géométrie et le rapport de forme de ces structures.

Il est également possible d'utiliser une technologie de gravure RIE (pour Reactive Ion Etching) pour réaliser les structures sub-longueur d'onde ainsi que les voies de clivage à partir d'un masque unique.

En résumé, l'invention a pour principal avantage de permettre la réalisation de traitements antireflet ou haute réflectivité optimisés par gravure de structures sub-longueur d'onde aboutissant à l'obtention de matériaux artificiels dont on maîtrise l'indice de réfraction. Par ailleurs, le procédé de fabrication selon la présente invention présente l'avantage de permettre la production collective, avec les moyens technologiques actuels, de dispositifs de lumière aux performances améliorées et homogènes.

**Revendications**

1.  Procédé de fabrication collectif d'une pluralité de dispositifs laser à partir d'un substrat constitué d'un empilement de couches de matériaux semi-conducteurs et destiné à former des cavités émissives desdites dispositifs laser,
    ledit substrat comprenant une zone active (1) incluse dans ledit empilement de couches de matériaux semi-conducteurs, et dans laquelle peut se propager, selon une direction de propagation, un faisceau lumineux (4) présentant une ou plusieurs longueurs d'onde,
    ledit procédé comportant :

    la réalisation d'un masque de gravure unique présentant une pluralité de zones, une zone correspondant à un dispositif laser et comprenant:

une partie permettant la gravure de voies de clivage (VC) permettant la séparation des cavités laser,

une partie permettant la gravure d'une paroi comprenant des structures verticales (5) de dimension plus petite que la longueur d'onde dans une direction transverse à la direction de propagation du faisceau lumineux (4), ces structures appelées structures sub-longueur d'onde (5) constituant une structure anti-reflet (AR) assurant une fonction anti-reflet, c'est-à-dire une réflectivité inférieure à 10% vis-à-vis de la ou des longueurs d'onde, ladite paroi constituant une face de sortie orthogonale au faisceau lumineux,

une partie permettant la gravure d'une seconde paroi constituant une structure haute réflectivité (HR), c'est-à-dire possédant une réflectivité supérieure à 90% vis-à-vis de la ou des longueurs d'onde, ladite seconde paroi étant opposée et parallèle à la paroi constituant la structure anti reflet (AR), ladite structure haute réflectivité (HR) étant constituée d'une alternance de N strates à indice de réfraction fort, c'est-à-dire supérieur ou égal à 3, et de (N-1) strates d'air, lesdites strates étant d'épaisseur optiques égales, ladite structure haute réflectivité formant un miroir de Bragg,

ledit procédé comportant en outre :

une unique étape de gravure dudit substrat à travers ledit masque unique, desdites structures verticales sub-longueur d'onde (5), desdites structures haute réflectivité (HR) ainsi que desdites voies de clivages (VC) de manière à réaliser collectivement lesdites dispositifs laser comprenant lesdites cavités émissives laser dont la longueur est imposée par ledit masque, ladite gravure reposant sur l'utilisation d'une source plasma haute densité.

2. Procédé de fabrication d'une pluralité de dispositifs laser selon la revendication 1, **caractérisé en ce que** la zone active (1) est formée d'un nombre entier de périodes constituées chacune d'un empilement de couches épitaxiées de matériaux semi-conducteurs tels que InGaAs, AlInAs, GaAs, AlGaAs, InP, de manière à constituer par exemple un laser à cascade quantique.

3. Procédé de fabrication d'une pluralité de dispositifs laser selon l'une des revendications1 ou 2, **carac-**
**térisé en ce que** :

• le faisceau lumineux (4) présente une longueur d'onde de 9 $\mu$m,
• chacune des strates de la structure à haute réflectivité (HR) possède une épaisseur optique d'environ 2,2 $\mu$m,
• la structure antireflet (AR) présente une période ($\Lambda$) d'environ 2,9 $\mu$m, une profondeur (d) d'environ 1,3 $\mu$m, une largeur (a) d'environ 0,5 $\mu$m et une hauteur gravée (h) supérieure à 9 $\mu$m.

4. Procédé de fabrication d'une pluralité de dispositifs laser selon la revendication 1 à 3 , **caractérisé en ce que** la source plasma haute densité est obtenue par couplage inductif.

5. Procédé de fabrication d'une pluralité de dispositifs laser selon l'une quelconque des revendications 1 à 4 , **caractérisé en ce que** la gravure dans un substrat constitué d'un empilement de couches de matériaux semi-conducteurs formant une cavité émissive repose sur l'utilisation d'une technologie de gravure RIE.

**Patentansprüche**

1. Verfahren für die kollektive Herstellung einer Vielzahl von Laservorrichtungen aus einem Substrat, das von einem Halbleitermaterialschichtstapel gebildet wird und dazu bestimmt ist, Sendekavitäten der Laservorrichtungen zu bilden,
wobei das Substrat eine aktive Zone (1) umfasst, die in den Halbleitermaterialschichtstapel eingeschlossen ist und in der sich gemäß einer Ausbreitungsrichtung ein Strahlenbündel (4) ausbreiten kann, das eine oder mehrere Wellenlängen aufweist,
wobei das Verfahren einschließt:

die Herstellung einer einzigen Gravurmaske, die eine Vielzahl von Zonen umfasst, wobei eine Zone einer Laservorrichtung entspricht und umfasst:
einen Teil, der die Gravur von Spaltungswegen (VC) erlaubt, was die Trennung der Laserkavitäten erlaubt,
einen Teil, der die Gravur einer Wand erlaubt, die vertikale Strukturen (5) mit einer Abmessung umfasst, die kleiner ist als die Wellenlänge in einer transversalen Richtung zur Ausbreitungsrichtung des Strahlenbündels (4), wobei diese als Unterwellenlänge-Strukturen (5) bezeichneten Strukturen eine Antireflexstruktur (AR) bilden, die eine Antireflexfunktion erfüllen, das heißt, eine Reflektivität unter 10 % gegenüber der oder den Wellenlängen haben, wobei die Wand eine zum Strahlenbündel orthogonale Ausgangsfläche bildet,

einen Teil, der die Gravur einer zweiten Wand erlaubt, die eine Hochreflexstruktur (HR) bildet, das heißt, eine Reflektivität über 90 % gegenüber der oder den Wellenlängen aufweist, wobei die zweite Wand der Wand, die die Antireflexstruktur (AR) bildet, gegenüberliegt und parallel zu dieser ist, wobei die Hochreflexstruktur (HR) von einer Wechselfolge von N Schichten mit starkem Refraktionsindex gebildet wird, das heißt, über oder gleich 3, und von (N-1) Luftschichten, wobei die Schichten optisch gleich dicht sind, wobei die Hochreflexstruktur einen Bragg-Spiegel bildet,

wobei das Verfahren ferner einschließt:

einen einzigen Schritt zur Gravur, von dem Substrat durch die einzige Maske, der vertikalen Unterwellenlänge-Strukturen (5), der Hochreflexstrukturen (HR) sowie der Spaltungswege (VC) derart, dass die Laservorrichtungen, die die Laser-Sendekavitäten, deren Länge von der Maske bestimmt wird, kollektiv hergestellt werden, wobei die Gravur auf der Verwendung einer hochdichten Plasmaquelle basiert.

**2.** Herstellungsverfahren einer Vielzahl von Laservorrichtungen nach Anspruch 1, **dadurch gekennzeichnet, dass** die aktive Zone (1) von einer ganzen Zahl von Perioden gebildet wird, die jeweils von gestapelten Expitaxieschichten aus Halbleitermaterialien wie InGaAs, AlInAs, GaAs, AlGaAs, InP gebildet wird, so dass beispielsweise ein Quantenkaskadenlaser gebildet wird.

**3.** Verfahren zur Herstellung einer Vielzahl von Laservorrichtungen nach einem der Ansprüche 1 oder 2, **dadurch gekennzeichnet, dass**:

• das Strahlenbündel (4) eine Wellenlänge von 9 $\mu$m aufweist,
• jede der Schichten der Hochreflexstruktur (HR) eine optische Dicke von zirka 2,2 $\mu$m besitzt,
• die Antireflexstruktur (AR) eine Periode (A) von zirka 2,9 $\mu$m, eine Tiefe (d) von zirka 1,3 $\mu$m, eine Breite (a) von zirka 0,5 $\mu$m und eine gravierte Höhe (h) über 9 $\mu$m aufweist.

**4.** Verfahren zur Herstellung einer Vielzahl von Laservorrichtungen nach einem der Ansprüche 1 bis 3, **dadurch gekennzeichnet, dass** die hochdichte Plasmaquelle durch induktive Kopplung gewonnen wird.

**5.** Verfahren zur Herstellung einer Vielzahl von Laservorrichtungen nach einem der Ansprüche 1 bis 4, **dadurch gekennzeichnet, dass** die Gravur in ein Substrat, das von einem Halbleitermaterialschichtstapel gebildet wird, der eine Sendekavität bildet, auf der Verwendung einer RIE-Gravurtechnologie basiert.

## Claims

**1.** A method for collectively manufacturing a plurality of laser devices from a substrate constituted by a stack of layers of semi-conductor materials and designed to form emissive cavities of said laser devices,

said substrate comprising an active zone (1) included in said stack of layers of semi-conductor materials and through which a light beam (4) with one or more wavelengths can propagate along a propagation direction,

said method including:

the production of a single etching mask having a plurality of zones, with a zone corresponding to a laser device and comprising:
a part allowing the etching of cleaving channels (VC) allowing the separation of the laser cavities;
a part allowing the etching of a wall comprising vertical structures (5), the size of which is smaller than the wavelength in a direction transverse to the direction of propagation of said light beam (4), said structures being referred to as subwavelength structures (5) constituting an anti-reflective structure (AR) providing an anti-reflection function, i.e. with reflectivity below 10% in relation to the one or more wavelengths, said wall constituting an output face orthogonal to said light beam;
a part allowing the etching of a second wall constituting a high reflectivity structure (HR), i.e. having reflectivity above 90% in relation to the one or more wavelengths, said second wall being opposite and parallel to the wall constituting the anti-reflective structure (AR), said high reflectivity structure (HR) being constituted by alternating N strata with a high refractive index, i.e. greater than or equal to 3, and (N-1) air strata, said strata being of equal optical thickness, said high reflectivity structure forming a Bragg mirror;

said method further including:

a single step of etching from said substrate, through said single mask, said subwavelength vertical structures (5), said high reflectivity structures (HR), as well as said cleaving channels (VC) so as to collectively produce said laser devices comprising said emissive laser cavities, the length of which is imposed by said mask, said etching being based on the use of a high density plasma source.

2. The method for manufacturing a plurality of laser devices according to claim 1, **characterised in that** said active zone (1) is formed from a whole number of periods each constituted by a stack of epitaxied layers of semi-conductor materials such as InGaAs, AlInAs, GaAs, AlGaAs, InP, so as to constitute a quantum cascade laser, for example.

3. The method for manufacturing a plurality of laser devices according to any of claim 1 or 2, **characterised in that**:

    • the wavelength of said laser beam (4) is 9 μm;
    • the optical thickness of each stratum of said high reflectivity structure (HR) is approximately 2.2 μm;
    • the anti-reflective structure (AR) has a period (Λ) of approximately 2.9 μm, a depth (d) of approximately 1.3 μm, a width (a) of approximately 0.5 μm and an etched height (h) of more than 9 μm.

4. The method for manufacturing a plurality of laser devices according to claims 1 to 3, **characterised in that** said high density plasma source is obtained by inductive coupling.

5. The method for manufacturing a plurality of laser devices according to any one of claims 1 to 4, **characterised in that** the etching in a substrate constituted by a stack of layers of semi-conductor materials forming an emissive cavity is based on the use of RIE technology.

FIG.1

FIG.2

FIG.3

FIG.4a

**FIG.4b**

**FIG.4c**

FIG.5

EP 2 160 808 B1